# EUROPEAN PATENT APPLICATION

(11) **EP 4 797 882 A1**
(43) Date of publication of application: **26.08.2026**
(21) Application number: 25158888.5
(22) Date of filing: 19.02.2025
(51) Int. Cl.: H05K 1/02, H01L 23/367

(54) **SURFACE MOUNTABLE HEAT DISSIPATOR FOR DISSIPATING HEAT FROM A HEAT GENERATING COMPONENT ON A PCB**

(71) Applicant: ICEpower a/s, 2860 Søborg (DK)
(72) Inventor: ANDERSEN, Thomas, 2830 SØBORG (DK)
(74) Representative: Lind Edlund Kenamets Intellectual Property AB

(57) **Abstract**

A surface mountable heat dissipator configured to be in thermal contact with a designated heat generating component such as a transistor on a printed circuit board the heat dissipator is formed by a strip of sheet metal bent into a loop, two ends of the bent strip of sheet metal are joined to render the loop a closed loop a mounting portion of the bent strip of sheet metal is substantially flat, and is configured to be surface mounted.

A closed loop of relatively thin metal gives the heat dissipator satisfactory mechanical stability with a relatively small amount of material, thereby reducing manufacturing costs and mass. The low mass ensures that only a low amount of force is exerted upon the heat dissipator and its solder joins when it is subject to external shocks and vibrations. This increases robustness and lifetime of the overall product implementing the heat dissipator.

## Description

### Field of the invention

The present invention relates to a heat dissipator for surface mounting on a printed circuit board, a method for manufacturing thereof and a printed circuit board comprising such a heat dissipator.

### Background of the invention

Some electric components, such as MOSFETs and integrated circuits, generate heat during operation. In some cases, the amount of heat may harm the component, temporarily or permanently reducing its performance or in worst case, completely incapacitating the component. There is, therefore, a need for dissipating the heat generated by such components.

Some heat generating components are mounted on a printed circuit board (PCB), presenting opportunities and challenges. The PCB itself can in such cases act as a heat dissipator for the component mounted on a heat conducting plate of the PCB at little extra cost. The heat dissipating performance of the PCB is, however, limited and might not be enough.

Some PCBs, therefore, have a big heat sink structure mounted on the other side of the PCB from the heat generating component. The big heat sink structure is connected to the heat conducting plate via a set of heat conducting vias running through the PCB. This solution requires a lot of material, increasing costs, while the vias are necessarily restricted in size, which limits the amount of heat conducted away from the component. The vias additionally restrict trace routing below the component and requires cutting of a ground plane of the PCB.

Another strategy is to mount a heat dissipator on the surface of the printed circuit board that the component is on. Depending on the cooling needs of a component or components from which the heat dissipator has been mounted to take up heat energy, different dimensions of the heat dissipator are required. A heat dissipator with more surface area can dissipate more heat to the surrounding air, making cooling more efficient. More surface area requires using more material, however, which leads to the heat dissipator being more expensive.

To provide more efficient heat dissipation, while still keeping costs down, ideally a smaller, and easier to manufacture, heat dissipator is needed.

In WO02076166 a heat sink is disclosed which comprises two copper lands configured to be mounted on the surface of a PCB, mechanically fixed to a bent strip of sheet metal of aluminum, which has been formed into a serpentine pattern. Said heat sink is configured to straddle a component the heat sink acts as a heat dissipator for.

The heat sink disclosed in WO02076166 has a relatively complex geometry, leading to the cost of bending being unnecessarily high. The serpentine pattern of the bent strip of sheet metal leads to lower mechanical stability. Assembly of the heat sink is also rendered unnecessarily complex and expensive by including mechanical affixing of two lands to the strip of sheet metal, that are to be soldered to a PCB.

### Summary of the invention

It is an object of the current invention to provide a heat dissipator mitigating at least some of the problems of the existing solutions.

According to a first aspect of the invention, this and other objects are achieved by a surface mountable heat dissipator configured to be in thermal contact with a designated heat generating component on a printed circuit board. The heat dissipator is formed by a strip of sheet metal bent into a loop, wherein two ends of the bent strip of sheet metal are joined to form a closed loop, wherein a mounting portion of the bent strip of sheet metal is substantially flat, so as to enable surface mounting of the heat dissipator.

By "strip of sheet metal" is intended a metal strip which is several times wider than it is thick, preferably at least 10 times wider. For example, it may be ten times wider than it is thick. In some embodiments, a thickness of the strip of sheet metal may be less than 1 mm, preferably less than 0.4 mm. This allows outer corners of the heat dissipator to be sharp, while also enabling good heat conductivity along the length of the strip of sheet metal.

A closed loop of relatively thin metal gives the heat dissipator satisfactory mechanical stability with a relatively small amount of material, thereby reducing manufacturing costs and mass. The low mass ensures that only a low amount of force is exerted upon the heat dissipator and its solder joins when it is subject to external shocks and vibrations. This increases robustness and lifetime of the overall product implementing the heat dissipator.

The mounting portion may be mounted (e.g. soldered) to a printed circuit board so as to be in thermal contact with a heat generating component. The thermal contact is preferably ensured by direct soldered contact between the heat dissipator and a heat guide of the component. However, sufficient thermal contact may also be provided by the electrically conducting layer of the PCB, e.g. by mounting the heat dissipator on the same solder pad as the heat generating component. Alternatively, the heat dissipator is mounted (e.g. soldered) directly onto a heat generating component on a PCB.

A top portion, opposite the mounting portion, may be substantially flat and parallel to the mounting portion. A flat top portion parallel to the mounting portion allows the heat dissipator to be engaged by a pick and place machine, which lowers costs of assembling a PCB comprising a heat dissipator of the above-disclosed kind.

A cross-section of the closed loop has first extension (L1) in a direction orthogonal to a plane of the mounting portion, and a second extension (L2) along the mounting portion, wherein a ratio between the first extension and the second extension may be at least two, preferably at least three, and more preferably at least four.

This means that the heat dissipator will be elongated, with a greater dimension of the heat dissipator extending out from the PCB when the heat dissipator is mounted on the PCB. This is beneficial, as air can be expected to be cooler, and move more quickly, at increasing distance from the PCB surface.

The cross-section of the closed loop may conceivably be any number of shapes, including a triangle, two straight lines connected by curves, a trapezoid, or a rectangle.

In some embodiments, the cross-section of the closed loop is trapezoidal or isosceles trapezoidal. Bending the strip of sheet metal into a closed loop with this shape of cross-section further increases the stability of the heatsink. An even greater stability is achieved by a heat sink bent into a closed loop with a substantially rectangular cross-section.

Two opposite ends of the bent strip of sheet metal may be joined by many different methods. For instance, they may be joined by soldering, spotwelding or welting. If the strip of sheet metal is bent so as to create an overlapping region where the two opposite ends overlap, they may advantageously be joined by clinching as a cost-effective alternative.

In some embodiments, the mounting portion has a substantially square cross-section. The square cross-section allows the heat dissipator to be placed on a PCB with the loop facing any of two directions. This allows the loop to better align with an air flow direction on the PCB, increasing heat dissipating performance.

In some embodiments, the mounting portion comprises a wetting hole running through the bent strip of sheet metal. The wetting hole allows for a more stable soldering of the heat dissipator to a PCB. The mounting portion may comprise more than one wetting hole, preferably at least two wetting holes, even more preferably at least three wetting holes.

The wetting holes may be arranged such that a plane view of the mounting portion is rotationally asymmetric. In other words, an angular position of the mounting portion may be determined based on the position of the holes in relation to the outer contour of the mounting portion. A set of holes, e.g. three holes, may be arranged in a rotationally asymmetric or periodic pattern (e.g. a triangle). Further, one or several holes may be placed offset from a center of the mounting portion. A rotationally asymmetric mounting portion will allow a pick and place machine to determine the orientation of the heat dissipator, allowing placing all heat dissipators of a PCB, if there are several heat dissipators, with the same orientation.

The bent strip of sheet metal may comprise at least 70 wt.% copper, preferably at least 80 wt.% copper, even more preferably at least 90 wt.% copper. This is advantageous as copper has good heat conducting abilities, making copper a good choice of material for a heat dissipator.

The top portion may have a substantially equal form and shape as the mounting portion. This makes the heat dissipator symmetric to a degree where it would achieve its object also when mounted upside down.

Two bottom outer bends of the bent strip of sheet metal may have an outside setback of less than 0.8 mm, preferably less than 0.6 mm. This feature enables an increase of contact between the heat dissipator and a heat plate of the designated component, increasing thermal contact.

According to a second aspect of the invention, this and other objects are achieved by a method for manufacturing a heat dissipator configured to be in thermal contact with a designated heat generating component on a printed circuit board, comprising the steps of: obtaining a strip of sheet metal and bending it into a loop such that a substantially flat mounting portion is formed enabling surface mounting of the heat dissipator. Two opposite ends of the bent strip of sheet metal are then joined. By joining the two opposite ends the loop is rendered a closed loop as defined above.

This allows for manufacturing a heat dissipator with the advantages described above relating to high heat dissipation performance cost efficiency.

In some embodiments the two opposite ends of the bent strip of sheet metal are joined by clinching. This allows for manufacturing a heat dissipator with the advantages described above.

A cross-section of the closed loop may be a substantially elongated trapezoidal cross-section, preferably a substantially elongated rectangular cross-section, to achieve a greater stability in the manufactured heat dissipator.

According to a third aspect of the invention, this and other objects are achieved by a printed circuit board having mounted thereon a heat generating component, and an above-disclosed heat dissipator, wherein the heat dissipator is in thermal contact with the heat generating component in order to dissipate heat generated by the component. Such a printed circuit board enjoys the advantages described above for dissipating heat from the heat generating component.

### Brief description of the drawings

The present invention will be described in more detail with reference to the appended drawings, showing currently preferred embodiments of the invention.
Figure 1 illustrates a perspective view of a printed circuit board comprising a plurality of MOSFETs, each of which have an adjacent heat dissipator.
Figures 2a and 2b illustrate perspective views of the heat dissipator of Fig. 1 in greater detail.
Figure 2c illustrates a perspective views of a heat dissipator according to a further embodiment of the invention.
Figures 3a-c illustrate plane views of the heat dissipator in Fig. 2a-b.
Figures 4a-b illustrates a zoomed-in plane view of two different heat dissipators with different outside setback values and a component heat plate abutting each heat dissipator.
Figure 5 is a flowchart of the method for manufacturing a heat dissipator according to an embodiment of the invention.

### Detailed description of preferred embodiments

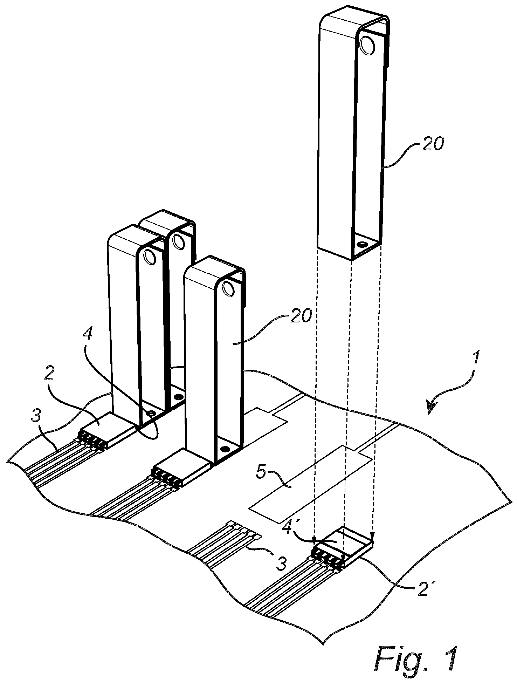

Figure 1 illustrates a printed circuit board 1 (PCB) with a plurality of surface mounted electric components. At least some of the components are heat generating components 2, in the illustrated example MOSFETs. Each component 2 is surface mounted on the PCB 1 in electrical contact with selected paths of the electrically conducting layer 3. A heat dissipator 20 is surface mounted so as to be in thermal contact with one of the components 2. This arrangement of heat dissipator 20 and component 2 allows the heat dissipator 20 to dissipate heat generated by the component 2.

In one example, the component 2 has a heat plate 4 facing the PCB 1 and in thermal contact with a designated solder pad 5 of the electrically conducting layer 3. In this case, the heat dissipator 20 is surface mounted onto the PCB 1 on the designated soldering pad 5, immediately adjacent to the component 2, such that it the dissipator 20 abuts the heat plate 4. A second heat dissipator 20 may be surface mounted immediately next to the first one, such that two heat dissipators 20 combine to dissipate heat from the component 2.

In another example, the component 2' has a heat plate 4' on its top side, facing away from PCB 1. In this case, the heat dissipator 20 is surface mounted onto the top of the component 2'.

The heat dissipator 20 is made from a strip of sheet metal which is bent to form a closed loop. The cross section of the closed loop may have any shape, and illustrated examples include trapezoidal and rectangular shape.

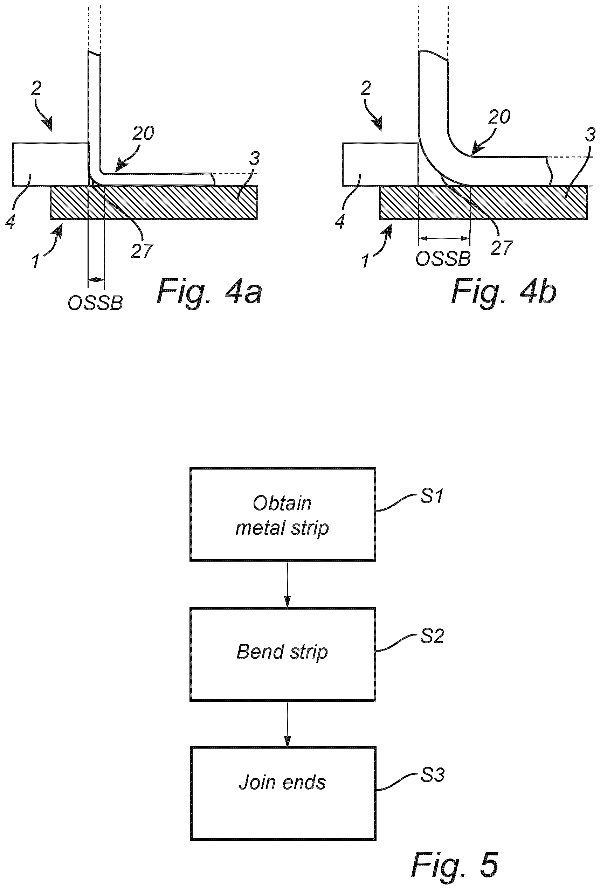

By a strip of sheet metal is meant a piece of metal which thickness is substantially smaller than its width which is substantially smaller than its length. In the illustrated example, the metal strip 10 is made from a copper alloy with 90 wt. % copper but any sufficiently heat conducting and plastically deformable material may be used. The sheet metal may be plated with tin or nickel to prevent corrosion and enhance solderability. The width of the metal strip 10 may be chosen depending on the application, but in the present example it may have a width of 5 mm. The thickness T of the metal strip 10 is, in the illustrated example, 0.3 mm. A larger thickness would increase heat conductivity of the metal strip 10, while a smaller thickness would allow the heat dissipator 20 to have sharper outer corners, as discussed in more detail with reference to figure 4.

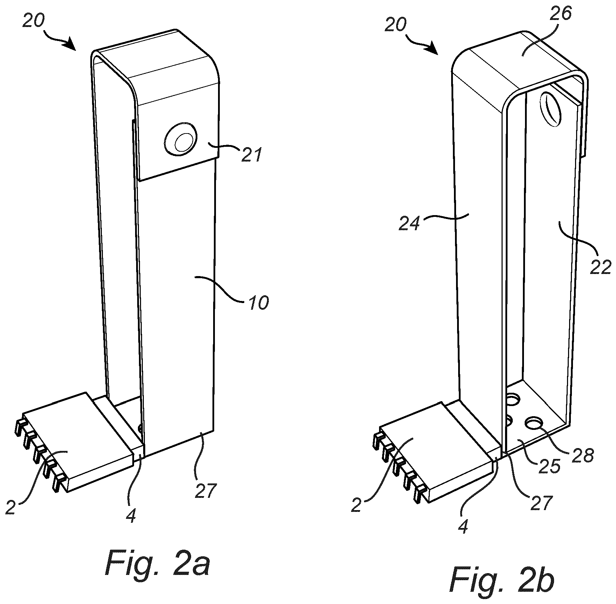

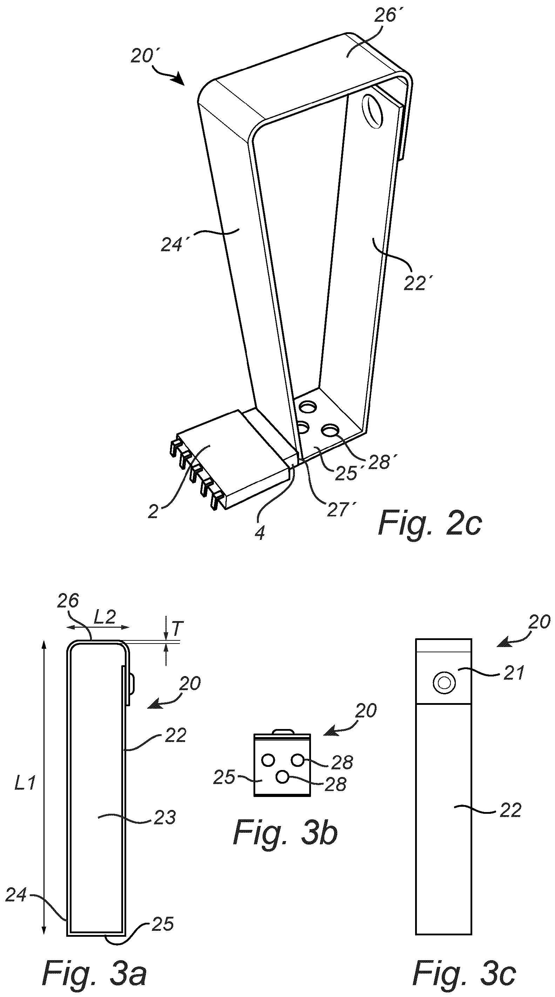

The metal strip has bent along its length four times so that the heat dissipator 20 comprises four straight sides. Bent this way, the metal strip 10 forms a loop with a substantially rectangular cross-section (figure 1, 2a-b, 3a-c) or trapezoidal cross-section (figure 2c).

In the examples more closely illustrated in figures 2a-c and 3a-c, two opposite ends of the strip overlap in an overlapping region 21 at a side called a first fin 22. Viewing the embodiment in figures 2a-b, the cross-section is rectangular with each side of the rectangular cross-section 23 corresponding to a respective side of the loop. The two opposite ends are joined by clinching in the overlapping region 21 such that they form the first fin 22. Clinching entails squeezing the two ends between a punch and an extensible die. In other embodiments the two opposite ends may be joined by a different method than clinching, such as soldering, spotwelding or welting. A side opposite of the first fin 22 constitutes a second fin 24. A side facing the PCB 1 constitutes a base 25, also referred to as a mounting portion. A side opposite of the base 25 constitutes a top 26.

Being formed out of a single elongated sheet of metal, the first fin 22, the base 25, the second fin 24 and the top 26, are all of an equal width and thickness, except that the first fin has a greater thickness in the overlapping region 21. In the illustrated example, the fins 22, 24 are parallel to each other, and the base 25 and the top 26 are parallel to each other. Fins of other embodiments of the heat sink 20 such as the one in figure 2c will not be parallel. The fins 22, 24 have a greater length than the base 25 and the top 26, and are equally long. The base 25 and the top 26 are also substantially equally long, with the top 26 being longer by a length equal to the thickness T of the strip 10 due to how the loop is bent to create the overlapping region 21.

All surfaces facing out from the heat dissipator 20, including the surfaces of the mounting portion 25 and the top 26, are substantially flat.

The illustrated base 25 comprises wetting holes 28 in a rotationally non-symmetric pattern, extending through the base 25.

The length of the first and second fin 22, 24 is not so tall as to exceed a maximum allowed distance from the circuit board 1, and tall enough to make outside areas of the fins 22, 24 big enough to dissipate heat generated by a heat generating component 2 it is configured to dissipate heat from. Being tall, the fins 22, 24 also extend into a space further away from the PCB 1 where air is cooler and moves faster, thereby increasing heat dissipating performance. In the illustrated example the fins 22, 24 have a length L1 of 26 mm. In the illustrated example the thickness T, is 0.3 mm.

The top 26 and base 25 are shorter than the fins 22, 24, and in the illustrated example the base 25 and top 26 have lengths L2 of 5.5 mm and 5.8 mm respectively. The width of the four sides 22, 24, 25, 26 is determined by the width of the metal strip 10, in the illustrated example 5 mm. As a consequence, the mounting portion 25 and the top 26 both have a substantially square cross section.

As mentioned above, the thickness of the metal strip 10 is chosen so that the strip can be bent to form sharp corners. This is illustrated in figures 4a-b, showing two bends 27 of a heat dissipator 20 adjacent to a heat plate 4 of a heat generating component 2, again a MOSFET. By "sharp corner" is here intended a bend with an outside setback, OSSB, of 0.5 mm. The outside setback represents the area of noncontact between the heat dissipator 20 and the heat plate 4. The smaller the setback, the better the contact. The outside setback of a 90 degree bend can be defined as a sum of the thickness T of the metal strip 10 and the inner radius of curvature, r.

The illustrated heat dissipator 20 is configured to be mounted on a PCB 1 or a heat generating component 2 using a pick and place machine with a vacuum nozzle, which can engage with the flat top 26. The pick and place machine is able to determine which fin of the heat dissipator 20 is the first fin 22 based on rotation of the rotationally non-symmetric pattern of the wetting holes 28. The flat top 26 and the non-symmetrically arranged wetting holes 28 allow the pick and place machine to engage the heat dissipator 20 and to place it with the first fin 22 facing a particular direction. The heat dissipator 20 will be placed on a designated soldering pad 5 of the electrically conductive layer 3 of the PCB 1 in direct contact with a heat plate 4 of a component 2 for which it will dissipate heat. After placing all surface mounted components, including the heat dissipators 20, on the PCB 1, the PCB 1 is moved into a reflow oven where all components, including the heat dissipators 20 are reflow soldered onto the PCB 1. The wetting holes 28 serve a second purpose of allowing for more stable soldering of the heat dissipator 20 to the printed circuit board 1.

After soldering, the heat plate 4 and the heat dissipator 20 are in thermal contact both via the electrically conductive layer 3, and via the direct contact between the heat plate 4 and the heat dissipator 20. If several heat dissipators 20 are mounted on the PCB 1, they are preferably all mounted with their first fin 22 facing the same direction.

A process for manufacturing of an above-disclosed heat dissipator 20 is carried out in several steps. First in step S1, an elongated strip of sheet metal of appropriate length is obtained. As indicated above, in the illustrated example the metal strip has a width of 5 mm and a thickness of 0.3 mm.

The metal strip 10 is then, in step S2, bent four times along its length, with appropriate distances between the bends to produce above-described dimensions of four resulting sides, with two longer sides having a length of 26 mm, and two shorter sides having a length of 5.5 mm and 5.8 mm respectively, counting a first and a last section as one side, as they are substantially co-planar and overlap in an overlapping region 21. As an example, if the metal strip 10 is 66.3 mm long, then the overlapping region will have a length of 3 mm, given the dimensions indicated above.

The first and the second sections are then joined by clinching within the overlapping region 21 in step S3.

The person skilled in the art realizes that the present invention by no means is limited to the preferred embodiments described above. On the contrary, many modifications and variations are possible within the scope of the appended claims. For example, the cross section of the loop 23 does not necessarily have to be substantially rectangular along the entirety of its circumference. The first and second fins 22, 24 could, for instance, comprise a variety of bends and twists. Adding this kind of variation in shape still maintains the main concept of the current invention and does not constitute adding technical details outside the scope of the current invention.

## Claims

1. A surface mountable heat dissipator (20) configured to be in thermal contact with a designated heat generating component on a printed circuit board (1),
wherein the heat dissipator (20) is formed by a strip of sheet metal (10),
**characterized in that** the strip of sheet metal (10) is bent into a loop,
wherein two ends of the bent strip of sheet metal are joined to form a closed loop,
wherein a mounting portion (25) of the bent strip is substantially flat, so as to enable surface mounting of the heat dissipator (20).

2. The heat dissipator (20) according to claim 1, wherein a top portion (26) opposite to the mounting portion (25) is substantially flat and parallel to the mounting portion (25).

3. The heat dissipator (20) according to claim 1 or 2, wherein a cross-section of the closed loop has a first extension (L1) in a direction orthogonal to a plane of the mounting portion, and a second extension (L2) along the mounting portion (25), wherein a ratio between the first extension and the second extension is at least two, preferably at least three, and more preferably at least four.

4. The heat dissipator (20) according to claim 3, wherein the cross-section (23) is substantially trapezoidal, preferably isosceles trapezoidal.

5. The heat dissipator (20) according to claim 3, wherein the cross-section (23) is substantially rectangular.

6. The heat dissipator (20) according to any of the previous claims, wherein the two ends of the bent strip of sheet metal (10) are joined by clinching.

7. The heat dissipator (20) according to any of the previous claims, wherein two bottom outer bends (27) of the bent strip of sheet metal (10) have an outside setback (OSSB) of less than 0.8 mm, preferably less than 0.6 mm.

8. The heat dissipator (20) according to any of the previous claims, wherein the mounting portion (25) has a substantially square cross-section.

9. The heat dissipator (20) according to any of the previous claims, wherein the mounting portion (25) comprises at least one wetting hole (28), preferably at least two wetting holes (28), even more preferably at least three wetting holes (28) extending through the bent strip of sheet metal (10).

10. The heat dissipator (20) according to claim 9, wherein the at least one wetting hole (28) is placed such that the mounting portion (25) is rotationally asymmetric.

11. The heat dissipator (20) according to any of the preceding claims, wherein a thickness (T) of the strip of sheet metal (10) is less than 1 mm, preferably less than 0.4 mm.

12. A method for manufacturing a heat dissipator (20) configured to be in thermal contact with a designated heat generating component (2) on printed circuit board (1), comprising the steps of:
- obtaining a strip of sheet metal (S1),
- bending it into a loop such that a substantially flat mounting portion (25) is formed enabling surface mounting of the heat dissipator (S2), and
- joining two opposite ends of the bent strip of sheet metal (S3).

13. The method according to claim 12, wherein the joining step (S3) is performed by joining the two opposite ends by clinching.

14. The method according to any of claims 12-13, wherein a cross-section of the closed loop is a substantially elongated trapezoidal cross-section, preferably an elongated rectangular cross-section (23).

15. A printed circuit board (1) having mounted thereon:
a heat generating component (2), and
a heat dissipator (20) according to claim 1, wherein the heat dissipator (20) is in thermal contact with the heat generating component (2) dissipating generated heat.
